# EUROPEAN PATENT APPLICATION

(11) **EP 1 285 895 A1**
(43) Date of publication of application: **26.02.2003**
(21) Application number: 02702805.9
(22) Date of filing: 07.03.2002
(51) Int. Cl.: C03C 25/10, D21H 13/40

(54) **CHOPPED STRAND FOR GLASS PAPER**

(30) Priority: 21.03.2001 JP 2001080692
(71) Applicant: NIPPON ELECTRIC GLASS COMPANY, Limited, Otsu-shi, Shiga 520-8639 (JP)
(72) Inventor: IRITANI, Akihiro, Nippon Electric Glass Co., Ltd, Otsu-shi, Shiga 520-8639 (JP)
(74) Representative: Tetzner, Michael, Dipl.-Ing.
(86) International application number: JP0202130
(87) International publication number: WO02074712

(57) **Abstract**

A chopped strand for a glass paper, characterized in that it has a sizing agent comprising at least one of a surfactant and a water-soluble polymer, and pyrophosphate, which are adhered to the surface thereof. Preferably, pyrophosphate is adhered in an amount of 0.001 to 0.3 mass%. Pyrophosphate may be potassium pyrophosphate and/or sodium pyrophosphate. The strand may further have a silane coupling agent adhered to the surface thereof in an amoun tof 0.001 to 0.1 mass%.

## Description

### TECHNICAL FIELD

The present invention relates to a chopped strand for glass paper serving as a raw material of glass paper that is used for building materials such as tile carpets or roofings, or printed wiring boards.

### BACKGROUND ART

As a raw material for producing glass paper, a chopped strand is used that is produced by drawing out molten glass through a lot of nozzles formed in a bottom surface of a platinum bushing so as to form it into fibers, then applying a sizing agent to the surfaces thereof to bundle them into a strand and cutting it into a length of 3 to 50mm. In the process of producing the glass paper, a water soluble high polymer, a surfactant and so on are dissolved in a producing tank to prepare white water, and the chopped strand is put into the white water, which is then subjected to agitation by propeller blades or the like thereby to achieve fiber opening, then, according to a method similar to that for paper produced from pulp, the glass paper is produced in a paper machine and subjected to dehydration and drying.

As glass paper producing methods, there are a batch type and a continuous type. In recent years, there has been occurring a change from the batch type to the continuous type for the purpose of improving the production efficiency. In the batch type, since a chopped strand in white water is entirely used up per preparation, a residence time of glass filaments obtained by fiber-opening the chopped strand in the white water is approximately constant. On the other hand, in the continuous type, after putting a chopped strand into white water, there exist glass filaments that are immediately subjected to production, and glass filaments that stay for a long time. Therefore, the mean residence time of glass filaments in the white water is longer than that of the batch type.

In the production of the foregoing chopped strand, a sizing agent is used. A sizing agent generally used contains no greater than 10 mass% of each of a surfactant represented by an alkyl imidazoline cationic surfactant and a water soluble high polymer such as polyethylene oxide, polypropylene oxide or polyvinyl alcohol. The sizing agent may further contain a compound such as a silane coupling agent, a wetting agent, a pH regulator or an antifoaming agent, if necessary.

In the production of the chopped strand, a sizing agent containing a natural raw material such as starch or vegetable oil as a main component may be used. Such a sizing agent has functions of protecting the surfaces of the spun filaments, giving a bundling force to bundle several hundreds to several thousands of filaments into a strand, and giving the smoothness to the glass surface upon production.

In case of producing glass paper from the conventional chopped strand according to the continuous type producing method, a strand that is not completely fiber-opened or a strand subjected to secondary cohesion, i.e. a so-called flock, tends to frequently occur. The flock becomes a cause to induce unevenness in thickness of glass paper. Accordingly, in case of using the continuous type producing method, a chopped strand is required to have both properties, i.e. a quick fiber opening property to become filaments immediately after introduction into white water and an anti-secondary cohesion property that allows glass filaments to exist without being tangled with each other even if staying in white water for a long time.

Therefore, an object of the present invention is to provide a chopped strand for glass paper, wherein fiber opening of the chopped strand in white water is quick, and glass filaments after the fiber opening are reluctant to be subjected to secondary cohesion.

### DISCLOSURE OF THE INVENTION

As a result of repeating various experiments for accomplishing the foregoing object, the present inventor has found that, by adhering pyrophosphate onto the surface of a chopped strand in addition to at least one of a conventional surfactant and a conventional water soluble high polymer, there can be obtained a chopped strand for glass paper wherein fiber opening of the chopped strand in white water is quick, and monofilaments after the fiber opening are reluctant to be subjected to secondary cohesion, and has come to propose the present invention.

According to the present invention, there can be obtained a chopped strand for glass paper, characterized in that a sizing agent having at least one of a surfactant and a water soluble high polymer, and pyrophosphate are adhered to the surface thereof.

Since the surfactant and the water soluble high polymer are liable to dissolve relative to water, bundling forces among glass filaments in white water disappear to shorten a fiber opening time. On the other hand, pyrophosphate is rich in affinity with glass and thus strongly adsorbed onto the glass, so that the smoothness on the surfaces of the glass filaments is increased. Therefore, this chopped strand for glass paper is such that fiber opening of the chopped strand in white water is quick, and the glass filaments after the fiber opening are reluctant to be subjected to secondary cohesion.

Preferably, pyrophosphate is made of at least one of potassium pyrophosphate and sodium pyrophosphate.

Preferably, the adhesion amount of pyrophosphate is 0.001 to 0.3 mass%. If the adhesion amount of pyrophosphate is less than 0.001 mass%, the foregoing effect can not be exhibited, while, if greater than 0.3 mass%, it is not economical, and the fiber opening property of the chopped strand is lowered or the product strength tends to be lowered, which is thus not desirable.

If the adhesion amount of an organic substance (water soluble high polymer or surfactant) excluding an inorganic substance such as pyrophosphate is 0.01 to 1.00 mass%, preferably 0.02 to 0.20 mass%, the fiber opening property of the strand becomes excellent, which is thus desirable.

As a specific surfactant, an alkyl imidazoline cationic surfactant, a nonionic surfactant or an alkyl amido derivative is desirable. On the other hand, as a water soluble high polymer, polyethylene oxide, polypropylene oxide, polyvinyl alcohol, polyoxyethylene rosin ester, polyoxyethylene alkyl polyamino ether, polyoxyethylene alkyl amide ether or the like is desirable.

If 0.0001 to 0.1 mass% of a silane coupling agent is adhered onto the surface, an impregnating property of resin is improved so as to be effective in improving the strength of the product, which is thus desirable. As a silane coupling agent, an epoxy silane coupling agent, an amino silane coupling agent, an ureide silane coupling agent, a methacrylic silane coupling agent, a vinyl silane coupling agent, a styryl silane coupling agent or the like is desirable.

For a sizing agent, it is possible to add a wetting agent, a pH regulator, an antifoaming agent or the like used in a normal chopped strand for glass paper, other than the foregoing components, if necessary.

### BEST MODE FOR EMBODYING THE INVENTION

Hereinbelow, chopped strands for glass paper according to embodiments of the present invention will be described in detail.

Tables 1 and 2 show chopped strands for glass paper of the present invention (embodiments Nos. 1 to 9), while Table 3 shows chopped strands for glass paper of comparative examples (comparative examples Nos. 10 to 14).

**Table 1**

| embodiment | 1 | 2 | 3 | 4 |
|---|---|---|---|---|
| adhesion amount (mass%) | | | | |
| cationic surfactant | 0.03 | 0.03 | 0.03 | 0.03 |
| nonionic surfactant | 0.02 | 0.02 | 0.02 | 0.02 |
| polyethylene oxide | 0.05 | 0.05 | 0.05 | 0.05 |
| potassium pyrophosphate | 0.03 | 0.01 | 0.20 | - |
| sodium pyrophosphate | - | - | - | 0.03 |
| epoxy silane coupling agent | - | - | - | - |
| ignition loss (mass%) | 0.10 | 0.10 | 0.10 | 0.10 |
| sizing agent adhesion amount (mass%) | 0.13 | 0.11 | 0.30 | 0.13 |
| fiber opening time (min.) | 0.3 | 0.3 | 0.6 | 0.4 |
| cohesion time (min.) | 240 | 130 | >600 | 220 |

**Table 2**

| embodiment | 5 | 6 | 7 | 8 | 9 |
|---|---|---|---|---|---|
| adhesion amount (mass%) | | | | | |
| cationic surfactant | - | 0.08 | 0.03 | 0.03 | 0.03 |
| nonionic surfactant | - | - | 0.02 | 0.02 | 0.02 |
| polyethylene oxide | 0.10 | - | 0.05 | - | - |
| potassium pyrophosphate | 0.03 | 0.03 | 0.03 | 0.3 | 0.005 |
| sodium pyrophosphate | - | - | - | - | - |
| epoxy silane coupling agent | - | - | 0.02 | - | - |
| ignition loss (mass%) | 0.10 | 0.08 | 0.12 | 0.05 | 0.05 |
| sizing agent adhesion amount (mass%) | 0.13 | 0.11 | 0.15 | 0.35 | 0.055 |
| fiber opening time (min.) | 0.5 | 0.8 | 1 | 0.5 | 0.8 |
| cohesion time (min.) | 200 | 500 | 60 | 100 | 80 |

**Table 3**

| embodiment | 10 | 11 | 12 | 13 | 14 |
|---|---|---|---|---|---|
| adhesion amount (mass%) | | | | | |
| cationic surfactant | 0.03 | 0.09 | 0.015 | 0.03 | 0.03 |
| nonionic surfactant | 0.02 | 0.06 | 0.01 | 0.02 | 0.02 |
| polyethylene oxide | 0.05 | 0.15 | 0.025 | 0.05 | 0.05 |
| potassium pyrophosphate | - | - | - | - | - |
| sodium pyrophosphate | - | - | - | - | - |
| sodium phosphate | | | | 0.03 | |
| sodium sulfate | | | | | 0.03 |
| epoxy silane coupling agent | - | - | - | - | - |
| ignition loss (mass%) | 0.10 | 0.30 | 0.05 | 0.10 | 0.10 |
| sizing agent adhesion amount (mass%) | 0.10 | 0.30 | 0.05 | 0.13 | 0.13 |
| fiber opening time (min.) | 0.3 | 4 | 0.1 | 0.4 | 0.3 |
| cohesion time (min.) | 20 | 150 | 5 | 15 | 20 |

The chopped strands for glass paper shown in Tables 1 to 3 were prepared in the following manner.

First, molten glass having a composition of E glass was drawn out through a bushing having 4000 nozzles to prepare monofilaments having a diameter of 10µm. One obtained by adding pyrophosphate to a sizing agent containing at least one of a surfactant and a water soluble high polymer was applied to the surfaces of the monofilaments using an applicator so as to achieve each of the adhesion amounts shown in Tables 1 to 3. A large number of the thus treated monofilaments were gathered by a gathering shoe and bundled into one strand. The strand was wound on a winder to prepare a cake. Then, the strand was reeled off the cake and cut into 13mm, thereby to prepare a chopped strand for glass paper.

As the water soluble high polymer, polyethylene oxide was used. As a cationic surfactant, 2-heptadecenyl -hydroxyethyl imidazoline was used and, as a nonionic surfactant, a polyethylene glycol nonionic surfactant was used. Further, as an epoxy silane coupling agent, γ-glycidoxy propyltrimethoxy silane was used.

In Tables 1 to 3, the ignition loss indicates, in terms of mass%, a mass reduction amount when the chopped strand was heated up to 615°C, and represents an amount of adhesion of an organic substance in the sizing agent onto the surface of the chopped strand. When 1000g of white water is put into a 100cc beaker, the fiber opening time represents a time from when 3g of the foregoing chopped strand is introduced into the beaker while agitation is performed at 400rpm using propeller blades with a diameter of 70mm, until the chopped strand is entirely formed into monofilaments so that there is no nonreleased strand. The cohesion time represents a time until the monofilaments are tangled with each other again to form a first flock.

As clear from Tables 1 and 2, with respect to the embodiments Nos. 1 to 9, the fiber opening of each chopped strand in the white water was quick and the monofilaments after the fiber opening were reluctant to be subjected to the secondary cohesion.

On the other hand, as shown in Table 3, with respect to the comparative examples Nos. 10, 12, 13 and 14, the adhesion amount of each sizing agent containing no pyrophosphate was small, so that while the fiber opening of each chopped strand in the white water was quick, the monofilaments after the fiber opening were liable to be subjected to the secondary cohesion. On the other hand, with respect to the comparative example No. 11, the adhesion amount of the sizing agent containing no pyrophosphate was large, so that while the monofilaments after the fiber opening were reluctant to be subjected to the secondary cohesion, the fiber opening of the chopped strand in the white water was slow.

### INDUSTRIAL APPLICABILITY

A chopped strand for glass paper of the present invention is such that fiber opening of the chopped strand in white water is quick and monofilaments after the fiber opening were reluctant to be subjected to secondary cohesion. Accordingly, glass paper produced by using it is desirable when used for a building material such as a tile carpet or a roofing, or a printed wiring board.

## Claims

1. A chopped strand for glass paper, **characterized in that** a sizing agent having at least one of a surfactant and a water soluble high polymer, and pyrophosphate are adhered to the surface thereof.

2. A chopped strand for glass paper as set forth in claim 1, wherein an adhesion amount of said pyrophosphate is 0.001 to 0.3 mass%.

3. A chopped strand for glass paper as set forth in claim 1 or 2, wherein said pyrophosphate is made of at least one of potassium pyrophosphate and sodium pyrophosphate.

4. A chopped strand for glass paper as set forth in any of claims 1 to 3, wherein 0.0001 to 0.1 mass% of a silane coupling agent is adhered to the surface thereof.

5. A chopped strand for glass paper as set forth in claim 4, wherein said silane coupling agent has at least one of an epoxy silane coupling agent, an amino silane coupling agent, an ureide silane coupling agent, a methacrylic silane coupling agent, a vinyl silane coupling agent, and a styryl silane coupling agent.

6. A chopped strand for glass paper as set forth in any of claims 1 to 5, wherein an adhesion amount of said sizing agent is 0.01 to 1.00 mass%.

7. A chopped strand for glass paper as set forth in claim 6, wherein an adhesion amount of said sizing agent is 0.02 to 0.20 mass%.

8. A chopped strand for glass paper as set forth in any of claims 1 to 7, wherein said sizing agent is added with at least one of a wetting agent, a pH regulator and an antifoaming agent.

9. A chopped strand for glass paper as set forth in any of claims 1 to 8, wherein said surfactant has at least one of an alkyl imidazoline cationic surfactant, a nonionic surfactant and an alkyl amido derivative.

10. A chopped strand for glass paper as set forth in any of claims 1 to 9, wherein said water soluble high polymer has at least one of polyethylene oxide, polypropylene oxide, polyvinyl alcohol, polyoxyethylene rosin ester, polyoxyethylene alkyl polyamino ether, and polyoxyethylene alkyl amide ether.
